(19) Europäisches Patentamt
European Patent Office
Office européen des brevets

(11) **EP 4 300 117 A1**

(12) **EUROPÄISCHE PATENTANMELDUNG**

(43) Veröffentlichungstag:
**03.01.2024   Patentblatt 2024/01**

(21) Anmeldenummer: 23182250.3

(22) Anmeldetag: **29.06.2023**

(51) Internationale Patentklassifikation (IPC):
**G01R 33/34** (2006.01)

(52) Gemeinsame Patentklassifikation (CPC):
**G01R 33/34053; G01R 33/34092**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(30) Priorität: **01.07.2022   DE 102022206767**

(71) Anmelder: **Bruker Switzerland AG**
**8117 Fällanden (CH)**

(72) Erfinder: **Freytag, Nicolas**
**8122 Binz (CH)**

(74) Vertreter: **Kohler Schmid Möbus Patentanwälte**
**Partnerschaftsgesellschaft mbB**
**Gropiusplatz 10**
**70563 Stuttgart (DE)**

(54) **NMR-PROBENKOPF MIT EINER SENDE-EMPFANGSSPULE MIT VARIIERENDER LEITERBAHNBREITE**

(57)    Die Erfindung betrifft einen NMR-Probenkopf mit einer Sende-Empfangsspulenanordnung (100) mit einer ersten Sende-Empfangsspule (1) zur Erzeugung eines ersten HF-Magnetfeldes B1, wobei die erste Sende-Empfangsspule (1) einen elektrischen Leiter (2) mit mehreren Windungen (3) um eine Längsachse Z' umfasst,
wobei der elektrische Leiter (2) der ersten Sende-Empfangsspule (1) als bandförmiger Leiter (5) mit einer Leiterbahnbreite W ausgeführt ist,
der dadurch gekennzeichnet ist,
dass die Leiterbahnbreite W innerhalb jeder Windung (3) mindestens zweimal abnimmt und zweimal zunimmt. Mit der Erfindung kann ein NMR-Probenkopf bereitgestellt werden, der eine Sende-Empfangsspule aufweist, die eine maximale Güte bei gleichzeitiger Transparenz für weitere gegebenenfalls einzustrahlende HF-Magnetfeldern aufweist.

Fig. 1

EP 4 300 117 A1

**Beschreibung**

Hintergrund der Erfindung

Die Erfindung betrifft einen NMR-Probenkopf mit einer Sende-Empfangsspulenanordnung mit einer ersten Sende-Empfangsspule zur Erzeugung eines ersten HF-Magnetfeldes B1, wobei die erste Sende-Empfangsspule einen elektrischen Leiter mit mehreren Windungen um eine Längsachse Z' umfasst, wobei der elektrische Leiter der ersten Sende-Empfangsspule als bandförmiger Leiter mit einer Leiterbahnbreite W ausgeführt ist.

Eine Spule für einen NMR-Probenkopf mit einem bandförmigen Leiter ist bekannt aus [Privalov 1996].

Probenköpfe für die kernmagnetische Resonanzspektroskopie (NMR) können zur Untersuchung von verschiedenen Kernen eingesetzt werden. Um unterschiedliche Kerne anzuregen, ist es bekannt, mehrere, insbesondere zwei Spulen zu verwenden, die senkrecht aufeinander stehende Magnetfelder erzeugen (Kreuzspulen-NMR-Messköpfe). Hierbei besteht jedoch die Problematik, dass das Magnetfeld einer Spule durch den Leiter der anderen Spule gestört bzw. teilweise abgeschirmt wird.

[Gorkov 2007] offenbart eine Kreuzspulen-Resonatoranordnung für magic angle spinning (MAS) NMR-Messungen, bei der eine auf 15N-Kerne abgestimmte Solenoidspule innerhalb eines auf 1H-Kerne abgestimmten Ringspalt-Resonators angeordnet ist.

Eine weitere Kreuzspulen-Resonatoranordnung ist aus [Doty 2006] bekannt. Hier ist eine Solenoidspule mit variabler Steigung außerhalb einer auf 1H-Kerne abgestimmte Kreuzspule montiert. Die Kreuzspule ist eine auf 1H-Kerne abgestimmte Sattelspule, deren Feld transversal durch eine kreiszylinderförmige Messprobe strahlt. Die äußere Solenoidspule ist auf 13C und 15N Messfrequenzen abgestimmt und erzeugt weitere HF-Magnetfelder, die axial zur Messprobe ausgerichtet sind. Um eine ausreichende Transparenz für das magnetische Wechselfeld auf der 1H-Frequenz zu erreichen, müssen die Freiräume zwischen den Windungen der Solenoidspule ausreichend groß sein. Dies führt allerdings dazu, dass i.d.R. die Güte der Solenoidspule geringer ausfällt als das für die gegebene Spulengeometrie mögliche Optimum. Dies gilt sowohl für die Konfiguration mit Solenoidspule als innerer Spule wie auch für die Konfiguration mit der Solenoidspule außerhalb einer 1H Spule oder eines 1H-Resonators. Ein Teil des Güteverlustes soll in [Doty 2006] dadurch ausgeglichen werden, dass für die Solenoidspulen ein Leiter mit einem ovalen Querschnitt verwendet wird, wobei die lange Achse radial zur Längsachse Z' der Sende-Empfangsspule ausgerichtet ist. Dies erhöht allerdings den effektiven Durchmesser, auf dem sich die Stromdichte einstellt, so dass mit zunehmender Ovalität eine Reduktion des erzeugten HF-Feldes bei gleichem Strom eintritt.

Neben Spulengeometrien basierend auf Leitern mit rundem oder ovalem Querschnitt ist es auch bekannt, bandförmige Leiter für NMR-Probenköpfe zu verwenden. Insbesondere können solche Spulengeometrien auf einem zylinderförmigen Leiter strukturiert (z.B. indem eine metallische Schicht auf einem Träger mit zylindrischer Oberfläche strukturiert aufgebacht wird oder ein gleichförmig aufgebrachter Leiter durch subtraktive Herstellungsverfahren strukturiert wird) oder aus einem Zylindermantelförmigen Leiter ausgeschnitten werden. Diese Herstellungsverfahren ermöglichen eine größere Freiheit in der Gestaltung der Spulengeometrie, insbesondere einer variablen Steigung.

[US6751847] offenbart eine aus einem bandförmigen Leiter bestehende Spule mit konstanter Spaltbreite, die auf der Außenseite eines Zylindermantels aus einer elektrisch leitfähigen Schicht strukturiert ist.

[Privalov 1996] offenbart eine Spulengeometrie mit einem bandförmigen Leiter mit einer variablen Leiterbahnbreite und konstanter Spaltbreite. Durch die Variation der Breite soll die Inhomogenität in axialer Richtung minimiert werden. Der Abstand zwischen den Windungen ist klein gehalten, um die Inhomogenität des Feldes in radialer Richtung zu minimieren. Aufgrund der kleinen Abstände zwischen den Windungen weist diese Spulengeometrie jedoch eine geringe Transparenz auf und eignet sich daher nicht für eine Kreuzspulenanordnung.

Aufgabe der Erfindung

Es ist Aufgabe der Erfindung einen NMR-Probenkopf bereitzustellen, der eine Sende-Empfangsspule aufweist, die eine maximale Güte bei gleichzeitiger Transparenz für weitere gegebenenfalls einzustrahlende HF-Magnetfeldern aufweist.

Beschreibung der Erfindung

Diese Aufgabe wird erfindungsgemäß gelöst durch einen NMR-Probenkopf gemäß Patentanspruch 1.

Bei der Sende-Empfangsspule des erfindungsgemäßen NMR-Probenkopfs nimmt die Leiterbahnbreite W innerhalb jeder Windung mindestens zweimal ab und zweimal zu.

Die Leiterbahnbreite ist die Breite der Leiterbahn senkrecht zur Leitermitte. Erfindungsgemäß existieren innerhalb jeder Windung zwei Bereiche mit einer minimalen Leiterbahnbreite und zwei Bereiche mit einer maximalen Leiterbahnbreite. Die Leiterbahnbreite ist also erfindungsgemäß eine Funktion der Position entlang des Verlaufs des Leiters (W = W(t), wobei t ein Laufparameter ist, der zwischen 0 und der Windungszahl N läuft, mit $t \in \mathbb{R}$ und $0 \leq t \leq N$, $N \in \mathbb{R}$ ist die Anzahl Windungen). Durch die Bereiche minimaler Breite wird eine höhere Transparenz für Magnetfelder erreicht, während durch die Bereiche maximaler Breite die Güte der Sende-Empfangsspule optimiert wird. Auf diese Weise wird eine höhere Transparenz für Magnetfelder erreicht, ohne die Güte der Sende-Empfangsspule zu stark negativ zu beeinflussen.

Bei einer speziellen Ausführungsform weisen die Bereiche mit maximaler Leiterbahnbreite dieselbe Leiterbahnbreite auf.

Vorzugsweise variiert die Leiterbahnbreite W periodisch, insbesondere so, dass die Bereiche des elektrischen Leiters mit minimalen Werten für die Leiterbahnbreite bezüglich einer Rotation um die Längsachse um 180° versetzt angeordnet sind.

Die Bereiche des Leiters mit minimaler Leiterbahnbreite sind also vorzugsweise jeweils eine halbe Windung voneinander beabstandet. Entsprechend sind dann auch die Bereiche des Leiters mit maximaler Leiterbahnbreite jeweils eine halbe Windung voneinander beabstandet. Bereiche des elektrischen Leiters mit minimaler Leiterbahnbreite sind gegenüber den Bereichen mit maximaler Leiterbahnbreite bezüglich einer Rotation um die Längsachse Z' vorzugsweise um 90° verdreht angeordnet, also um ein Viertel einer Windung voneinander beabstandet. Eine Gerade durch jeden zweiten Bereich des elektrischen Leiters mit minimaler Leiterbahnbreite verläuft demnach parallel zur Längsachse Z'. Bei dieser Ausführungsform liegen Bereiche mit minimaler Leiterbahnbreite auf sich gegenüberliegenden Zylindermantelsegmenten, was dazu führt, dass auch Freiräume mit maximaler Leiterbahnbreite auf sich gegenüberliegenden Zylindermantelsegmenten angeordnet sind. Dadurch kann die Transparenz der Sende-Empfangsspulenanordnung erhöht werden, ohne die Güte der Spule zu stark negativ zu beeinflussen. Dies ist insbesondere für Kreuzspulen-Anordnungen vorteilhaft, wenn also ein zweites HF-Magnetfeld, das durch eine weitere Sende-Empfangsspulenanordnung erzeugt wird, dem ersten HF-Magnetfeld überlagert werden soll (s.u.). Das Probenvolumen ist dann für beide HF-Magnetfelder "sichtbar". Gleichzeitig kann die Sende-Empfangsspulenanordnung in den übrigen Bereichen eine größere Leiterbahnbreite aufweisen, wodurch die Güte der Spule erhöht wird. Eine Spule mit konstanter Leiterbahnbreite oder konstanter Spaltbreite weist bei gleicher Transparenz für ein weiteres HF-Magnetfeld eine tiefere Güte auf als die erfindungsgemäße Sende-Empfangsspule, insbesondere dann, wenn das Verhältnis Leiterbahnbreite zu Leiterbahnabstand < 5, besser <2 und insbesondere <1 ist.

Vorzugsweise variiert die Leiterbahnbreite W zwischen 0,1 mm bis 2 mm.

Weiterhin ist für den Fall einer Kombination aus erster Sende-Empfangsspule mit T ≠0, die ein HF-Magnetfeld erzeugt, das im Wesentlichen innerhalb der Messprobe in einer X'Z' Ebene eines kartesischen X', Y', Z'-Koordinatensystems liegt und einer weiteren Sende-Empfangsspule, die ein zweites HF-Magnetfeld B2 erzeugt, das in der Messprobe im Wesentlichen in einer Y'Z' Ebene liegt, eine Ausführung der ersten Sende-Empfangsspule von Vorteil, die vier Maxima und vier Minima pro Windung aufweisen, wobei die Minima in der X' und Y' Richtung und die Maxima unter 45° zwischen X' und Y' zu liegen kommen.

Besonders vorteilhaft ist es, wenn die Sende-Empfangsspule aus einer metallischen Schicht (Beschichtung) auf einem dielektrischen Träger ausgeführt wird. Dies ermöglicht maximale Flexibilität für die Ausführung der Struktur des Leiters. Als Träger eignen sich insbesondere Materialien mit geringen dielektrischen Verlusten, wie beispielsweise Saphir, Aluminiumoxidkeramik, Teflon, Aluminiumnitrit, Quarz und Glas.

Die Beschichtung kann auf der Innenseite und/oder der Außenseite des dielektrischen Trägers aufgebracht sein und mittels nasschemischer und/oder reaktiver/nichtreaktiver Vakuumätzverfahren und/oder Laserablationsverfahren strukturiert werden. Alternativ kann selektiv metallisiert werden, wobei insbesondere Vakuumdepositions- und galvanische Verfahren von Vorteil sind. Vakuumdepositionsverfahren sind aufgrund der hohen Präzision des Schichtwachstums und der Möglichkeit, eine hohe Reinheit der abgeschiedenen Materialien zu erreichen, insbesondere dann von Vorteil, wenn die Spule bei kryogenen Temperaturen betrieben wird. Galvanische Verfahren sind schnell und kostengünstig durchführbar, insbesondere für dicke Beschichtungen über 50 μm.

Ebenso vorteilhaft ist die Herstellung der Sende-Empfangsspule aus einem metallischen Rohr. Die Strukturierung kann durch Herausschneiden von nicht benötigten Bereichen z.B. durch Fräsen, Laser- oder Wasserstrahlschneiden aus einem rohrförmigen Rohling erfolgen. Vorteilhaft hieran ist eine kostengünstig erreichbare große Leiterbahndicke d, die deutlich größer ausfallen kann als bei Beschichtungsverfahren. Dies kann für Messproben mit einem Durchmesser größer oder gleich 5 mm, insbesondere größer oder gleich 10 mm und tiefen Messfrequenzen von Vorteil sein um eine hohe elektrische Leitfähigkeit der Spule erreichen zu können. Weiterhin kann eine solche Sende-Empfangsspule ohne Träger hergestellt werden, insbesondere ohne Träger zwischen Leiter und Messprobe, so dass die Effizienz erhöht wird. Dies ist insbesondere bei kleinen Messproben mit Durchmesser < 5 mm von Vorteil. Zur weiteren Verbesserung der Leitfähigkeit können Verfahren zur Verrundung der Schnittkanten (z. B. Trovalisieren) eingesetzt werden, oder die Schnittkanten beispielsweise durch Fräsen verrundet werden.

Vorzugsweise beträgt die Leiterbahndicke d der Leiterbahn (d. h. die Ausdehnung des elektrischen Leiters in radialer Richtung bezogen auf die Längsachse Z' der Sende-Empfangsspule) maximal 1 mm (vorzugsweise maximal 200 μm) und/oder ist mindestens so groß wie die doppelte Eindringtiefe des HF-Stromes in den elektrischen Leiter. Darüber hinaus ist es vorteilhaft, wenn die Leiterbahndicke mindestens 20 μm, vorzugsweise mindestens 100 μm beträgt. Unter Eindringtiefe ist die Tiefe zu verstehen, bei der die Stromdichte auf 1/e des Wertes an der Leiteroberfläche abgefallen ist (Skin-Effekt). Sie hängt vom Material des elektrischen Leiters und der Frequenz des damit erzeugten HF-Magnetfelds ab.

$$\delta = \sqrt{\frac{2\rho}{\omega\mu}} \, ,$$

wobei

ρ: spezifischer Widerstand,

$\mu = \mu_0 \mu_r$ : absolute Permeabilität,

$\omega = 2\pi f$: Kreisfrequenz.

Wird eine Sende-Empfangsspule bei mehreren Frequenzen eingesetzt, kann die die Leiterbahndicke d bei den tiefsten Einsatzfrequenzen jedoch auch d < 2δ sein.

Für Leiterbahndicke d der Leiterbahn, die größer 250 μm, insbesondere größer 500 μm, sind, weisen Sende-Empfangsspulen aus verrundetem Leitermaterial höhere Güten auf als Sende-Empfangsspulen aus Schichtmaterial, da sich die Stromdichte an den Verrundungen auf eine größere Fläche verteilt als bei einem rechteckförmigen Leiterquerschnitt und die genutzte Oberfläche des Leiters dadurch erhöht werden kann. Insbesondere ovale Leiterquerschnitte, wie sie z.B. durch das Pressen von kreisförmigen Drähten entstehen sind vorteilhaft.

Die Leiterbahnbreite W variiert vorzugsweise zwischen 0,5 mm und 2 mm. Bei geringen Leiterbahnbreiten als 0,5 mm ist die Herstellung schwierig, Randeffekte, die durch das Strukturieren entstehen, dominieren die Leitfähigkeit und Verunreinigungen im Rohmaterial können sich als problematisch erweisen. Bei Leiterbahnbreiten größer als 2 mm ist für in der NMR typische Messprobendimensionen keine Solenoidspule mit ausreichender Induktivität möglich, ohne radial mehrere Lagen anzuordnen. Sende-Empfangsspulen mit mehreren Lagen reduzieren jedoch die Transparenz für ein zweites HF-Magnetfeld stark, so dass sie für Kreuzspulenanordnungen unvorteilhaft sind.

Eine spezielle Ausführungsform sieht vor, dass die Windungen der Sende-Empfangsspule gegenüber der Längsachse Z' der Sende-Empfangsspule geneigt sind. Die Neigung ist definiert als Amplitude einer sinusförmigen Modulation der Z'-Position der Leitermittelebene über eine Windung. Eine Spule mit Neigung T ≠ 0 kann prinzipiell auch durch eine variable Steigung S'(t)= S(t) + T(t) cos(2π t + φ) (allgemeine Steigung) beschrieben werden. Wenn S'(t) als Fourierreihe geschrieben wird, dann beschreibt T den (t = 1)-periodischen Anteil der Steigung. Für jede Windung kann die Steigung geschrieben werden als:

$$S'(t) = S_0 + \sum_{k=1}^{\infty} \left( S_{k,a} \cos(k\, 2\pi\, t) + S_{k,b} \sin(k\, 2\pi\, t) \right),$$

wobei

$$S(t) = S'(t) - \left( S_{1,a} \cos(2\pi\, t) + S_{1,b} \sin(2\pi\, t) \right).$$

$(S_{1,a} \cos(2\pi t) + S_{1,b} \sin(2\pi t))$ kann als $T(t)\cos(2\pi t + \varphi)$ geschrieben werden, wobei T die Neigung und φ die Richtung der Neigung ist (i.d.R. ist φ = 0 oder φ = 90°).

Die Neigung T kann über den Verlauf t der Länge des elektrischen Leiters variieren (T=T(t)). In diesem Fall ist die Neigung abschnittsweise konstant, insbesondere für mindestens eine Halbwindung (halbe Windung). Die Neigung ändert sich dann also von Halbwindung zu Halbwindung, d.h. dass jede Halbwindung mit einer Neigung T gegenüber der Längsachse Z' geneigt ist, wobei für zumindest einen Teil der Halbwindungen (halbe Windung) T≠0 gilt. Die Neigung T der Windungen hat Einfluss auf die B1-Amplitude und die radiale Homogenität. Dies ist insbesondere für MAS NMR Messungen von Vorteil, da die Effizienz der Sende-Empfangsspule gesteigert werden kann, insbesondere, wenn diese als Solenoidspule ausgebildet ist oder solenoidförmige Abschnitte umfasst. Bei MAS NMR Messungen wird eine Messprobe um die Längsachse Z' rotiert, die vorzugsweise um den magischen Winkel θ (θ = 54,74°) gegenüber einer Z-Achse, die durch das statische Magnetfeld B0 definiert wird und in der sich im Betrieb (also wenn der NMR-Probenkopf in der NMR-Apparatur montiert ist) die längliche Ausdehnung des NMR-Probenkopfs erstreckt, verkippt ist. Durch die Neigung der Windungen der Sende-Empfangsspule können Feldkomponenten des HF-Magnetfelds B1 parallel zum statischen Magnetfeld B0 minimiert, respektive die Feldkomponenten des HF-Magnetfeld B1 orthogonal zum statischen Magnetfeld B0 maximiert werden. Durch das Neigen der Windungen steht jedoch, im Gegensatz zu konventionellen (nicht geneigten) Solenoidspulen, das HF-Magnetfeld B1 nicht mehr parallel zur Längsachse Z' der Spule, so dass die Leiter der Spule "dem von ihr erzeugten Feld im Weg stehen". Eine Reduktion der Leiterbahnbreite der geneigten Solenoidspule in diesen Bereichen erhöht die Sende-Effizienz und das mögliche Signal-zu-Rauschverhältnis einer erfindungsgemäßen geneigten Solenoidspule.

Eine besonders bevorzugte Ausführungsform des erfindungsgemäßen MR-Probenkopfs sieht vor, dass die Sende-Empfangsspulenanordnung mindestens eine weitere Sende-Empfangsspule zur Erzeugung eines zweiten HF-Magnetfelds B2 umfasst, dass die erste Sende-Empfangsspule und die weitere Sende-Empfangsspule um die gemeinsame Längsachse Z' angeordnet sind, derart, dass durch die erste Sende-Empfangsspule und die weitere Sende-Empfangsspule erzeugte HF-Magnetfelder B1, B2 senkrecht zueinander ausgerichtet sind; und dass die Leiterbahnbreite W des elektrischen Leiters der ersten Sende-Empfangsspule in dem Bereich, in dem die Flächennormale der ersten Sende-Empfangsspule parallel zum zweiten HF-Magnetfeld B2 steht, einen minimalen Wert (Verjüngung) aufweist. In anderen Worten ausgedrückt, im Bereich der Fläche der ersten Sende-Empfangsspule, die das HF-Magnetfeld B2 durchdringen muss, um die Messprobe im Field of View anzuregen, ist die Leiterbahnbreite W des elektrischen Leiters der ersten Sende-Empfangsspule minimal, um einen Transparenzbereich für B2 zu schaffen.

Die beiden Sende-Empfangsspulen sind vorzugsweise auf verschiedene Frequenzen abgestimmt. Senkrecht aufeinander stehende Felder B1, B2 bedeutet, dass das Volumenintegral des Skalarproduktes der Vektoren B1(x,y,z) und B2(x,y,z) mindestens über den Bereich des Field of Views der beiden Spulen, in dem eine Messprobe angeordnet wird, ungefähr null ist, i.e. es werden nur die B1, B2 Felder innerhalb der Messprobe betrachtet. Bei einer speziellen Ausführungsform wird die Entkopplung der beiden HF-Magnetfelder B1 und B2 durch ein Anpassungsnetzwerk erreicht, d.h. die unmittelbar durch die beiden Sende-Empfangsspulen erzeugten HF-Magnetfelder B1 und B2 müssen nicht exakt orthogonal zueinander sein.

Aufgrund des minimalen Werts der Leiterbahnbreite W des elektrischen Leiters der ersten Sende-Empfangsspule in dem Bereich, in dem die Flächennormale der ersten Sende-Empfangsspule (Vektor senkrecht zur Zylinderfläche der ersten Sende-Empfangsspule) parallel zum zweiten HF-Magnetfeld B2 steht, weist die erste Sende-Empfangsspulenanordnung für das zweite HF-Magnetfeld B2 eine hohe Transparenz auf.

Weiterhin vorteilhaft ist es, wenn ein Träger den Raum zwischen der ersten Sende-Empfangsspule und der weiteren Sende-Empfangsspule zumindest teilweise ausfüllt. Wird ein Material mit hoher Durchschlagsfestigkeit verwendet, dann können elektrische Durchschläge beim Senden von RF-Pulsen, insbesondere beim Senden simultaner RF-Pulse vermieden werden.

Bei einer speziellen Ausführungsform ist eine dritte Sende-Empfangsspulenanordnung zur Erzeugung eines dritten HF-Magnetfelds B3 vorhanden, wobei das dritte HF-Magnetfeld B3 vorzugsweise senkrecht zum ersten HF-Magnetfeld B1 und zum zweiten Magnetfeld B2 steht und die Leiterbahnbreite der ersten Sende-Empfangsspule in dem Bereich, in dem die Flächennormale der ersten Sende-Empfangsspule parallel zum dritten HF-Magnetfeld B3 steht, einen minimalen Wert aufweist.

Die Leiterbahnbreite W des Bandleiters der Sende-Empfangsspulenanordnung nimmt dann also entlang des Umfangs des Kreiszylinders der Spule periodisch im Bereich des B2-Feldes und des B3-Feldes ab. Jede Windung weist dann also vier Bereiche auf, an denen die Leiterbahnbreite einen minimalen Wert aufweist

Die weitere Sende-Empfangsspule ist vorzugsweise als eine Sattelspule oder ein Resonator, z.B. Alderman-Grant, Birdcage oder Loop-Gap Resonator, ausgebildet.

Vorzugsweise weist die erste Sende-Empfangsspule mindestens einen solenoidförmigen (spiralförmigen) Abschnitt auf. Insbesondere kann es sich bei der ersten Sende-Empfangsspule um eine Solenoidspule handeln. Vorzugsweise umfasst die Sende-Empfangsspule ausschließlich solenoidförmige Abschnitte, umfasst also insbesondere ausschließlich Windungen, die um die Längsachse Z' der Sende-Empfangsspule verlaufen.

Vorzugsweise umfasst die Sende-Empfangsspule mindestens drei Windungen.

Allgemein ist die Einhüllende des elektrischen Leiters einer kreiszylinderförmigen Solenoidspule folgendermaßen definiert (wobei die Enden der Spulen nicht durch die parametrische Darstellung der unten aufgeführten Formeln

$$\begin{pmatrix} R\sin(2\pi t) \\ R\cos(2\pi t) \\ P(t) * t \pm \frac{W(t)}{2} + T(t) * \cos(2\pi t + \varphi) \end{pmatrix}$$

erfasst werden.): in kartesischen Koordinaten , mit $t \in \{0...N\}$ (entsprechend auch für angefangene Windungen definiert)

wobei

$$P=\int_{tn}^{tn+1} S(t)\,dt$$ die Ganghöhe der Windungen (d.h. die Strecke, die über eine Windung in Z'-Richtung zurücklegt wird) und S die lokale Steigung ist, wobei tn das t am Anfang der n-ten Windung ist, d.h. tn = 0, 1, ...,

T die Neigung (hier definiert als Amplitude einer sinusförmigen Modulation der Z'-Position der Leitermittelebene über eine Windung),

R der Radius und

N die Windungszahl der Sende-Empfangsspule, mit $N \in \mathbb{R}$ und $3 \leq N$,

t ein Laufparameter ist, der zwischen 0 und einer Windungszahl der Sende-Empfangsspulenanordnung läuft, mit $t \in \mathbb{R}$ und $0 \leq t \leq N$.

Bevorzugt sind die Anzahl N der Windungen ganz- oder halbzahlig ( $N \in \mathbb{N}$ oder $2N \in \mathbb{N}$ ).

Eine spezielle Ausführungsform des erfindungsgemäßen MR-Probenkopfs sieht vor, dass der elektrische Leiter der ersten Sende-Empfangsspule einen Hinwicklungsabschnitt und einen Rückwicklungsabschnitt umfasst, wobei der Hinwicklungsabschnitt Hinwindungen umfasst und ausgehend von einem Anschlussbereich in einem vorgegebenen Windungssinn zu einem axialen Ende der Sende-Empfangsspule führt, wobei der Rückwicklungsabschnitt Rückwindungen umfasst und ausgehend vom axialen Ende der Sende-Empfangsspule im selben vorgegebenen Windungssinn zum Anschlussbereich führt, wobei die Windungen des Rückwicklungsabschnitts eine Ganghöhe P mit entgegengesetztem Vorzeichen zu denen des Hinwicklungsabschnitts aufweisen, und dass Hin- und Rückwindungen des elektrischen Leiters mit Ausnahme von Überkreuzungsbereichen, in denen sich die Hin- und Rückwindungen überkreuzen, auf einer gemeinsamen Zylindermantelfläche um die Längsachse Z' angeordnet sind (="Crisscross-Geometrie"). Die Sende-Empfangsspule weist bei dieser Ausführungsform also zwei solenoidförmige Leiterabschnitte auf (Hinwicklungsabschnitt und Rückwicklungsabschnitt).

Die Hin- und Rückwindungen befinden sich also auf demselben radialen Abstand um die Längsachse Z', d.h. es befinden sich gegenläufige Wicklungen auf einer gemeinsamen Fläche. Der Anschlussbereich dient zum Verbinden des elektrischen Spulenabschnitts mit einem Anpassnetzwerk (Matching Network) und kann Anschlüsse für mehrere elektrische Spulenabschnitte umfassen. Hinwicklungsabschnitt und Rückwicklungsabschnitt bilden einen Spulenabschnitt, der zwischen zwei Anschlüssen des Anschlussbereichs verläuft, so dass die angelegte Spannung zwischen dem Anfang der Hinwindungen und dem Ende der Rückwindungen des jeweiligen Spulenabschnitts anliegt. Um die Hinwindungen und Rückwindungen auf einer gemeinsamen Zylindermantelfläche anzuordnen, müssen sich die Hinwindungen und die Rückwindungen überkreuzen. Die Überkreuzungen werden auf einem möglichst wenig ausgedehnten Abschnitt des Umfangs (Überkreuzungsbereich) ausgeführt, wobei vorzugsweise der elektrische Leiter des Hinwicklungsabschnitts oder des Rückwicklungsabschnitts auf der Zylinderoberfläche verbleibt, wohingegen der jeweils andere elektrische Leiter in Form eines Brückenelements die ersten elektrischen Leiter überquert.

Mittels dieser speziellen Ausführungsform kann die Anordnung der Windungen und des Anschlussbereichs so gewählt werden, dass die Potentiale im Betrieb der Sende-Empfangsspule an vergleichbaren Positionen benachbarter Windungen (Zum Beispiel jeweils am Anfang der Windung oder in der Mitte oder am Ende) betragsmäßig gleich oder ähnlich groß sind. Das Potential wird als ähnlich angesehen, wenn gilt U1/UN=(N/2-1) / (N/2) mit U1: Spannung über erster Windung, UN: Spannung über N Windungen. Bei einer bevorzugten Ausführungsform, bei welcher der Spulenabschnitt eine Umkehrwindung umfasst, die im Betrieb einen Punkt mit Potential 0 aufweist (der durch ein sogenanntes balanced network eingestellt wird), sind die Hinwindungen und Rückwindungen eines Spulenabschnitts mit Ausnahme der Umkehrwindung daher vorzugsweise abwechselnd angeordnet. Auf diese Weise können die für eine elektrisch leitende Probe sichtbaren elektrische Felder reduziert und gleichzeitig anderweitige Performanceeinbußen verringert werden. Diese Ausführungsform ist insbesondere vorteilhaft für die Untersuchung von leitfähigen Messproben oder Messproben mit hohen dielektrischen Verlusten. Durch die erfindungsgemäße geometrische Anordnung der Leiterabschnitte auf einer gemeinsamen Zylinderoberfläche können die durch die Spulen des NMR-Probenkopfs in der Messprobe erzeugten elektrischen Felder stark minimiert werden.

Elektrische Felder können sowohl beim Senden als auch beim Empfangen zu Performanceeinbußen führen, z.B. dem Heizen der Messprobe, Verlängern von Pulswinkeln bei begrenzter Sendeleistung, Reduktion des Signal-zu-Rauschverhältnisses, etc..

Es können auch mehrere Spulenabschnitte vorgesehen sein, die jeweils einen Hinwicklungsabschnitt und einen Rückwicklungsabschnitt umfassen.

Bei einer speziellen Ausführungsform kann vorgesehen sein, dass die Steigung S der Windungen, insbesondere die Ganghöhe P, der ersten Sende-Empfangsspule entlang des Verlaufs des Leiters variiert. Die Steigung ist also abhängig von der Position entlang des Spulenabschnitts (S = S(t)). Eine Änderung der Steigung S= S(t) kann realisiert werden durch eine Änderung der Ganghöhe P , aber auch bereits durch eine Änderung der lokalen Steigung S innerhalb einer Windung bei konstantem P.

Bei konstanter Ganghöhe P kann die lokale Steigung S innerhalb einer Windung variieren und dabei sogar das Vorzeichen kehren. Die Ganghöhe P einer Windung soll als positiv bezeichnet werden, wenn die Z'-Koordinate der Mittellinien für tn+1 größer ist als die Z'-Koordinate bei tn. Dies gilt selbst dann, wenn die Z'-Koordinate im Intervall zwischen tn und tn+1 kleinere Werte annimmt als bei tn. Durch eine variable Ganghöhe P bzw. variable Steigung S kann die Homogenität entlang der Längsachse Z' der Sende-Empfangsspule (on-axis) verbessert werden.

Die mehreren Windungen können auch als Einzelresonatoren, die induktiv oder kapazitive gekoppelt sind, ausgeführt sein. Die Ganghöhe P beschreibt dann den Abstand zweier benachbarter Einzelresonatoren.

Für endliche Spulen fällt die Amplitude des B1-Magnetfelds an den axialen Enden ab. Durch eine Verringerung der Ganghöhe P an den axialen Enden kann erreicht werden, dass die Windungen dichter beieinanderliegen. Somit kann die aufgrund der Endlichkeit der Spule fehlende Stromdichte kompensiert werden. Eine Verbesserung der Homogenität entlang der Längsachse Z' für kurze Spulen, ergibt sich daher insbesondere dann, wenn die Ganghöhe P an den axialen Enden der Sende-Empfangsspule kleiner ist als im axialen Zentrum.

Betreibt man eine "kurze" Spule mit abwechselnd angeordneten Hin- und Rückwicklungsabschnitten (Criss-Cross-Geometrie - s. oben) an/in der Nähe der Eigenresonanz, ist es hingegen vorteilhaft, die Ganghöhe P in der Leitermitte zu reduzieren, da die ungefähr sinusförmige Stromverteilung entlang der Spulenabschnittlänge das erzeugte Feld im Bereich der Leiterenden reduziert, die entweder an einem Ende oder in der Spulenmitte zu liegen kommen.

Zur Verbesserung der Homogenität in radialer Richtung (off-axis) sieht eine weitere Ausführungsform des erfindungsgemäßen MR-Probenkopf vor, dass die Windungen der Sende-Empfangsspule entlang des Leiters eine variable Neigung gegenüber der Längsachse Z' der ersten Sende-Empfangsspule aufweisen, d.h. T = T(t).

Darüber hinaus besteht auch die Möglichkeit, die Sende-Empfangsspule oder Teile der Sende-Empfangsspule nicht helixförmig auszubilden, sondern als zero-pitch Spule. In diesem Fall weist mindestens eine Windung eine Steigung S = 0 über einen Großteil ihrer Länge auf. Eine solche Windung bildet dann einen nicht geschlossenen Ring, d.h. S(t) = 0 gilt für t = t0 ... t0+ 1- $\varepsilon$ oder t = t0+ $\delta$/2 ... t0+1-$\delta$/2, mit $\varepsilon$ >0, wobei $\varepsilon$ >0 einen Kurzschluss verhindert; t = t0 ist der Anfang der Windung. Die Ganghöhe P einer kompletten Windung hat jedoch einen Betrag ungleich 0, um eine Spaltbreite D > 0 zwischen den Windungen zu gewährleisten. Dabei kann P(t) konstant sein oder von Windung zu Windung variieren. Bei einer nicht geneigten Sende-Empfangsspulenanordnung (d.h. bei T = 0) ist die Windungen über den kompletten Bereich, in dem sie Steigung S = 0 aufweisen, senkrecht zur Längsachse Z' ausgerichtet. Eine solche Sende-Empfangsspulenanordnung kann als Kombination von nicht geschlossenen «Ringen» ohne Steigung und kurzen Windungsabschnitten mit Steigung S » 0 konzipiert werden. Bei einer speziellen Ausführungsform kann ein Abschnitt einer Windung senkrecht zur Längsachse Z' der Sende-Empfangsspule ausgerichtet sein. Die Sende-Empfangsspule kann also als Kombination aus nicht geschlossenen «Ringen» ohne (lokale) Steigung und Abschnitten des elektrischen Leiters mit Steigung S > 0 konzipiert werden. Dadurch kann das Verhältnis W/D von Leiterbahnbreite W zu Spaltbreite D über die Sende-Empfangsspulenanordnung hinweg konstant gehalten werden.

Dadurch kann besonders einfach die Güte der Sende-Empfangsspulenanordnung maximiert werden und die elektrischen Felder minimiert werden.

Eine besonders bevorzugte Ausführungsform sieht vor, dass sich mindestens zwei der Größen Neigung T, Steigung S, Leiterbahnbreite W über den Verlauf t der Länge des elektrischen Leiters der Sende-Empfangsspule ändern, insbesondere die Steigung S und einer der Größen Neigung T und Leiterbahnbreite W. Hierdurch kann eine auf das Signale-zu-Rausch-Verhältnis (SNR) optimierte Sende-Empfangsspule realisiert werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Fig. 1    zeigt eine perspektivische Darstellung einer Ausführungsform einer Sende-Empfangsspule, bei der die Leiterbahnbreite innerhalb jeder Windung periodisch variiert.

Fig. 2a  zeigt eine perspektivische Darstellung einer Ausführungsform einer Sende-Empfangsspulenanordnung für einen erfindungsgemäßen Probenkopf von schräg oben mit einer ersten Sende-Empfangsspule, die innerhalb einer weiteren Sende-Empfangsspule angeordnet ist (Kreuzspulen-Geometrie).

Fig. 2b  zeigt eine perspektivische Darstellung der Ausführungsform aus Fig. 2a von der Seite.

Fig. 3a  zeigt einen Ausschnitt eines solenoidförmigen Spulenabschnitts zur Veranschaulichung der Spulenparameter bei einer Spule mit geneigten Windungen.

Fig. 3b  zeigt einen Ausschnitt eines solenoidförmigen Spulenabschnitts zur Veranschaulichung der Spulenparameter bei einer Spule mit nicht geneigten Windungen.

Fig. 4  zeigt eine perspektivische Darstellung einer Ausführungsform einer Sende-Empfangsspule mit geneigten Windungen und periodisch variierender Leiterbahnbreite W innerhalb jeder Windung.

Fig. 5  zeigt eine perspektivische Darstellung einer Ausführungsform einer zero-pitch Sende-Empfangsspule mit periodisch variierender Leiterbahnbreite W innerhalb jeder Windung.

Fig. 6  zeigt eine Aufsichts-Darstellung einer Ausführungsform einer SendeEmpfangsspule mit variierender Ganghöhe P und periodisch variierender Leiterbahnbreite W innerhalb jeder Windung.

Fig. 7  zeigt eine Abwicklungsdarstellung einer Ausführungsform einer Sende-Empfangsspulenanordnung für einen erfindungsgemäßen Probenkopf mit einer ersten Sende-Empfangsspule mit einem Hinwicklungsabschnitt und einem Rückwicklungsabschnitt.

Fig. 8  zeigt eine erfindungsgemäße Sende-Empfangsspule mit von beiden Randbereichen zur Mitte hin zunehmender Neigung, von beiden Randbereichen zur Mitte hin zunehmender Steigung und periodisch variierender Leiterbahnbreite mit vier Maxima und vier Minima pro Windung.

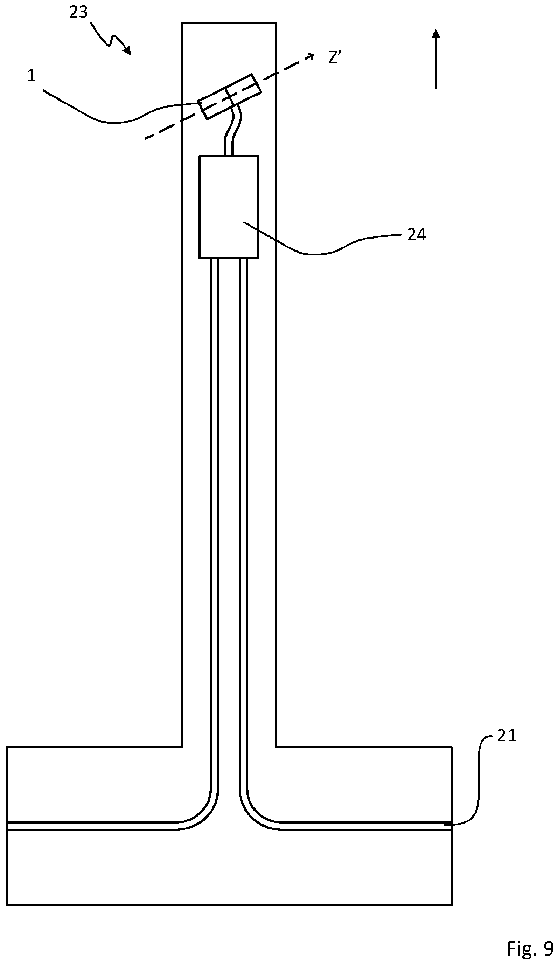

Fig. 9  zeigt eine schematische Darstellung eines erfindungsgemäßen NMR-Probenkopfs.

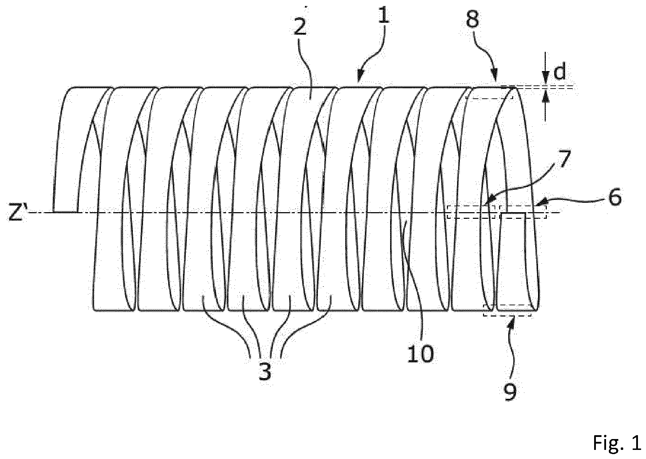

Die **Fig. 1** zeigt in einer perspektivischen Darstellung eine bevorzugte Ausführungsform einer ersten Sende-Empfangsspule **1** zur Erzeugung eines ersten HF-Magnetfelds B1 für einen erfindungsgemäßen NMR-Probenkopf. Die erste Sende-Empfangsspule 1 umfasst einen elektrischen Leiter **2** mit N (hier: N = 10) Windungen **3**, die um eine Längsachse **Z'** angeordnet sind. Die erste Sende-Empfangsspule 1 ist solenoidförmig ausgebildet und die Windungen 3 sind zylinderförmig um eine gedachte Kreiszylindermantelfläche gewickelt bzw. angeordnet.

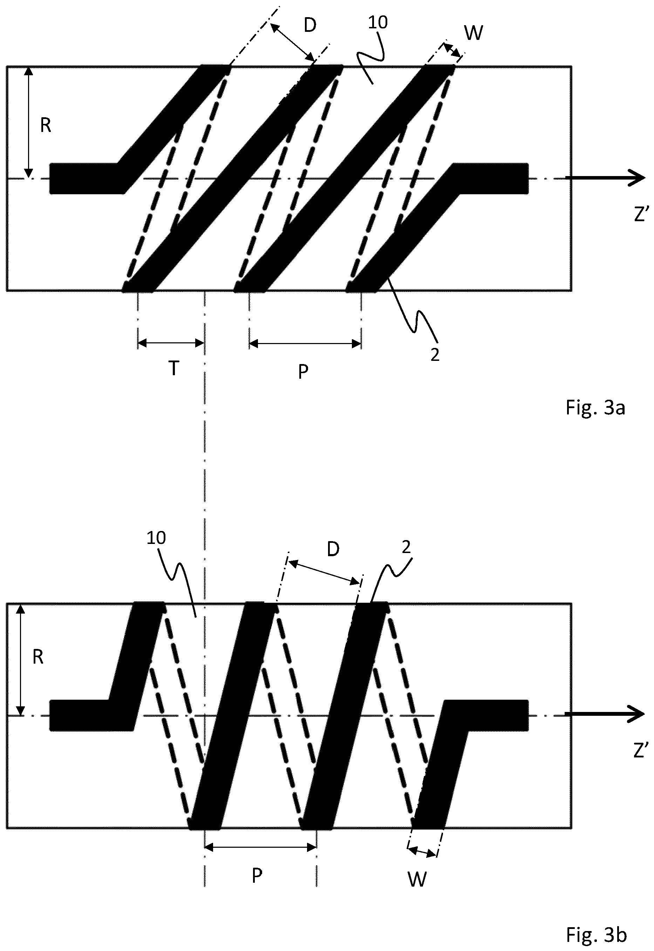

Der elektrische Leiter 2 ist als bandförmiger Leiter ("Leiterbahn") ausgebildet, d.h. der Leiter weist eine Leiterbahnbreite auf, die größer (insbesondere mindestens eine Größenordnung größer) ist als die Dicke des Leiters. Ein Bandleiter weist einen im Wesentlichen rechteckigen Querschnitt auf. Der elektrische Leiter 2 weist erfindungsgemäß eine variable Leiterbahnbreite W (siehe Fig. 3a, 3b) auf, d. h. W = W(t), wobei t ein Laufparameter ist, der zwischen 0 und einer Windungszahl der Sende-Empfangsspule 1 läuft, mit $t \in \mathbb{R}$ und $0 \leq t \leq N$, wobei N die Windungszahl der ersten Sende-Empfangsspule 1 ist mit $N \in \mathbb{R}$ und $3 \leq N$. Weiterhin weist die Leiterbahn eine Leiterbahndicke **d** auf. In der hier gezeigten Ausführungsform hat jede Windung einen ersten Bereich **6** mit einer (innerhalb der jeweiligen Windung) minimalen Leiterbahnbreite Wmin und einen zweiten Bereich **7** mit einer minimalen Leiterbahnbreite Wmin, die bezüglich einer Rotation um die Längsachse Z' um 180° versetzt angeordnet sind. Darüber hinaus weisen die Windungen jeweils einen dritten Bereich **8** mit einer maximalen Leiterbahnbreite Wmax, der bezüglich einer Rotation um die Längsachse Z' um 90° versetzt zum ersten Bereich 6 angeordnet ist, und einen vierten Bereich **9** mit einer maximalen Leiterbahnbreite Wmax, der bezüglich einer Rotation um die Längsachse Z' um 180° versetzt zum dritten Bereich 8 angeordnet ist. Die Leiterbahnbreite Wmax nimmt also innerhalb jeder Windung 3 zweimal zu und zweimal ab, wobei sich die Bereiche 6, 7 mit minimaler Leiterbahnbreite gegenüberliegen. Ebenso liegen sich die Bereiche 8, 9 mit maximaler Leiterbahnbreite gegenüber. In der hier gezeigten Ausführungsform erfolgt die Zunahme und Abnahme der Leiterbahnbreite W = W(t) periodisch. Weiterhin gilt W(k) = W(k+0.5) = Wmin und W(k+0.25) = W(k+0.75) = Wmax.

Die Leiterbahnbreite W im Umlauf kann in der gezeigten Ausführungsform folgendermaßen angegeben werden:

W(t) = W(0.5+(n-1)) bzw. W(0+(n-1)) < W(0.25+(n-1)) bzw. W(0.75+(n-1)) mit n einer natürlichen Zahl i.e. $n \in \mathbb{N}$. Für

eine periodische Verbreiterung und Verjüngung der Leiterbahn mit je zwei Maxima und zwei Minima pro Windung kann die Leiterbahnbreite als $W(t) = W_0 + \Sigma W_i (\sin(2\pi t + \varphi))^{2i}$ dargestellt werden, wobei die "Phase" $\varphi$ die Position der Minima/Maxima bestimmt. Allgemein können auch $W_0$ und $W_i$ eine Abhängigkeit von t aufweisen, insbesondere können sie für jede Windung oder Halbwindung verschieden sein.

Zwischen dem bandförmigen Leiter liegt ein Zwischenraum **10** mit einer variablen Spaltbreite **D** (s. Fig. 3a und Fig. 3b) vor. In den Bereichen 6, 7 mit minimaler Leiterbahnbreite W ist die Spaltbreite D des Zwischenraums 10 maximal. Bereiche 8, 9 mit einer großen Leiterbahnbreite W führen zu einer Verbesserung der Güte der ersten Sende-Empfangsspule 1, während Bereiche 6, 7 mit kleiner Leiterbahnbreite W aber großer Spaltbreite D eine erhöhte Transparenz für ggf. weitere einzustrahlende Magnetfelder bewirken. Dabei gibt es abhängig von der Dicke d der Leiterbahn ein optimales Verhältnis W/D, bei dem die Güte der Spule maximiert wird.

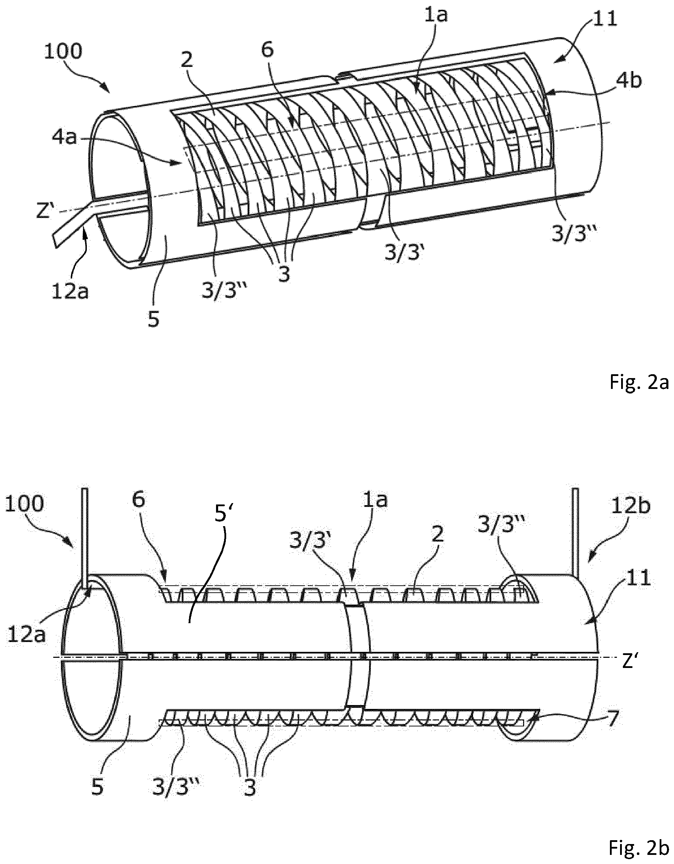

Die **Fig. 2a, 2b** zeigen zwei Blickwinkel einer perspektivischen Darstellung einer besonders bevorzugten Ausführungsform einer Sende-Empfangsspulenanordnung 100 mit einer solenoidförmigen ersten Sende-Empfangsspule **1a** zur Erzeugung des ersten HF-Magnetfelds B1 und mit einer weiteren Sende-Empfangsspule **11** zur Erzeugung des zweiten HF-Magnetfelds B2 für einen erfindungsgemäßen NMR-Probenkopf. Die erste Sende-Empfangsspule 1a ist hier koaxial, radial innerhalb der weiteren Sende-Empfangsspule 11 angeordnet, so dass das von der weiteren Sende-Empfangsspule 11 erzeugte zweite Magnetfeld B2 im Wesentlichen senkrecht auf dem von der ersten Sende-Empfangsspule 1a erzeugten ersten Magnetfeld B1 steht. Die weitere Sende-Empfangsspule 11 ist hier als Alderman-Grant-Resonator bestehend aus zwei Hälften **5** und **5'** ausgebildet und umgibt die erste Sende-Empfangsspule 1a radial. Die erste Sende-Empfangsspule 1a und die weitere Sende-Empfangsspule 11 sind so zueinander ausgerichtet, dass die Bereiche 6, 7 der ersten Sende-Empfangsspule 1a, in denen die Leiterbahnbreite W des elektrischen Leiters 2 der ersten Sende-Empfangsspule 1 den minimalen Wert aufweisen, innerhalb des "Fensters" der weiteren Sende-Empfangsspule 11 liegen, so dass das von der weiteren Sende-Empfangsspule 11 erzeugte zweite Magnetfeld durch die Bereiche 6, 7 (in Fig. 2a und 2b gestrichelt dargestellt) minimaler Leiterbahnbreite der ersten Sende-Empfangsspule 1a verläuft. Hierdurch weist die erste Sende-Empfangsspule 1a eine hohe Transparenz für das zweite HF-Magnetfeld B2 auf. Weiterhin weist die Sende-Empfangsspule 1a eine geringere Ganghöhe P in den Endbereichen auf. Da das Verhältnis der durchschnittlichen Leiterbahnbreite zur durchschnittlichen Spaltbreite W/D in dieser Ausführungsform konstant ist, nimmt die durchschnittliche Leiterbahnbreite W von einer zentralen Windung **3'** zu den endständigen Windungen **3″** ab. Alternativ zur Ausführungsform in Fig. 2 kann die weitere Sende-Empfangsspule 11 auch innerhalb der ersten Sende-Empfangsspule 1a angeordnet werden. Ebenso kann die weitere Sende-Empfangsspule auch als Sattelspule, insbesondere als Mehrwindungssattelspule statt als Resonator ausgeführt werden (nicht dargestellt).

Der elektrische Leiter 2 der ersten Sende-Empfangsspule 1 umfasst zwei Anschlussbereiche **12a, 12b**, die in der hier gezeigten Ausführungsform an je einem axialen Enden **4a, 4b** der ersten Sende-Empfangsspule 1a liegen. Dort kann die Sende-Empfangsspule 1b über die endständigen Windungen **3″** an ein Anpassnetzwerk (nicht näher dargestellt) angeschlossen werden, um die Sende-Empfangsspule 1b beim Senden von RF-Pulsen mit Energie zu versorgen, respektive das nach der Anregung der Messprobe in der Spule induzierte Signal zu detektieren.

Eine weitere Optimierung des erfindungsgemäßen NMR-Probenkopfs kann durch Variation von Spulenparametern der Sende-Empfangsspule erfolgen:
In **Fig. 3a** und **Fig. 3b** ist jeweils ein Ausschnitt einer solenoidförmigen Spule mit einem bandförmigen Leiter 2 (Leiterbahn) gezeigt, anhand derer zunächst die Spulenparameter veranschaulicht werden. Die solenoidförmige Spule in Fig. 3a und Fig. 3b ist entlang der Längsachse Z' (Spulenachse) angeordnet, wobei die Längsachse Z' senkrecht auf einer X'Y'-Ebene steht. Die solenoidförmige Spule wird durch die Leiterbahnbreite **W** der Leiterbahn 2, einer Spaltbreite **D** eines Zwischenraums **10**, einer Ganghöhe **P** der Windungen, einer Neigung **T** der Windungen und einem Radius **R** der Windungen parametrisiert. In der hier gezeigten Ausführungsform sind insgesamt drei Windungen gezeigt.

Die Leiterbahnbreite W gibt die Breite der Leiterbahn 2 an. Die Leiterbahnbreite W wird über die äußersten Punkte der Leiterbahn 2 bestimmt. In der hier gezeigten Ausführungsform ist die Leiterbahnbreite W entlang der Längsachse Z' konstant gehalten (d. h. W = const.).

Die Spaltbreite D gibt die Breite des Zwischenraums 10 zwischen den Windungen der Leiterbahn 2 an. Die Spaltbreite D wird über die äußersten Punkte des Bereichs zwischen den benachbarten Windungen der Leiterbahn 2 bestimmt.

Die Ganghöhe P der Windungen gibt den Abstand in Z'-Richtung zwischen zwei nebeneinanderliegenden Windungen an, also den Vortrieb der Spule nach einer kompletten Windung und wird über die Zentrallinie der Leiterbahn 2 bestimmt. Eine konstante Ganghöhe P schließt nicht aus, dass die Steigung S innerhalb einer Windung variiert.

Die Neigung T der Windungen gibt die Neigung der Windungen gegenüber der Längsachse Z' an und entspricht der Amplitude einer sinusförmigen Modulation der Z'-Position der Leitermittelebene über eine Windung. Bei über mehrere Windungen konstanter Steigung S und Neigung kann sie einfach bestimmt werden aus Max(Z(t) - Z(t+1)) - S)/2, wobei t im Intervall tn...tn+1 variiert.

Der Radius R der Windungen gibt den Radius an, auf dem die Leiterbahn 2 liegt.

Die in Fig. 3a und Fig. 3b gezeigten Solenoidspulen weisen jeweils eine konstante Leiterbahnbreite W, eine konstante Spaltbreite D und eine konstante Ganghöhe P auf, wobei es sich bei der im Fig. 3a gezeigten Spule um eine geneigte Spule (T ≠ 0) und bei der in Fig. 3b gezeigten Spule um eine nicht geneigte Spule (T = 0).

Allgemein ist die Zentrallinie der Leiterbahn 2 in kartesischen Koordinaten definiert als

$$\begin{pmatrix} R(t) * \sin(2\pi t) \\ R(t) * \cos(2\pi t) \\ P(t) * t + T(t) * \cos(2\pi t + \varphi) \end{pmatrix} \text{ mit } t \in \{0...N\},$$

wobei

$\varphi$ : Orientierung der Neigung der Windungen.

Die Einhüllende der Leiterbahn 2 in kartesischen Koordinaten ist definiert als

$$\begin{pmatrix} R(t) * \sin(2\pi t) \\ R(t) * \cos(2\pi t) \\ S(t) * t \pm W(t)/2 + T(t) * \cos(2\pi t + \varphi) \end{pmatrix} \text{ mit } t \in \{0...N\} \ .$$

Dabei ist die Leiterbahnbreite insbesondere $W(t) = W_0 + \Sigma W_i \ (\sin(2\pi \ t + k))^{2i}$ , die Neigung T ist konstant über jede Halbwindung, i.d.R. ist die Neigungsrichtung $\varphi = 0$ (Neigung um die Y' Achse) oder n/2 (Neigung um die X' Achse) und der Radius R(t) = R. Die in Fig. 1 und Fig. 2 gezeigten Ausführungsformen der erfindungsgemäßen Sende-Empfangsspule 1, 1a weisen jeweils eine variable Leiterbahnbreite W=W(t), eine konstante Steigung S = const. und Neigung T = 0 auf.

Im Folgenden werden spezielle Varianten der erfindungsgemäßen Sende-Empfangsspule-Geometrie beschrieben, mit denen die Performance des erfindungsgemäßen NMR-Spulenkopfs durch Variation der Spulenparameter weiter verbessert werden kann.

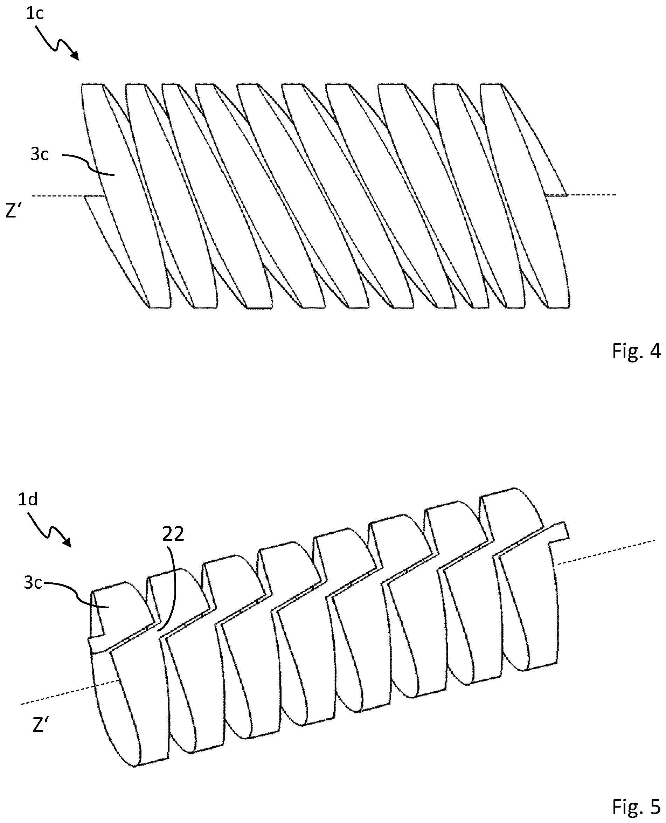

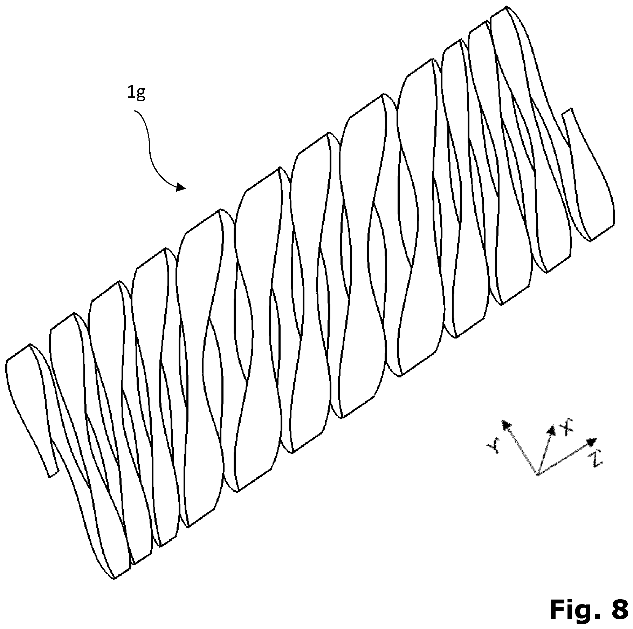

**Fig. 4** zeigt eine Ausführungsform der erfindungsgemäßen Sende-Empfangsspule **1c** mit periodisch variierender Leiterbahnbreite W innerhalb jeder Windung **3c**, wobei die Windungen gegenüber der Längsachse Z' der Sende-Empfangsspule 1 geneigt sind (T≠0) und die Minima der Leiterbahnbreite an den Orten der Maxima der durch die Neigung definierten sinusförmigen Modulation der Leiterposition auftreten. Sende-Empfangsspulen mit geneigten Windungen 3c können besonders vorteilhaft in MAS-Anordnungen verwendet werden, bei dem die Längsachse Z' der Sende-Empfangsspule 1 gegenüber der Z-Achse des NMR-Probenkopfs 23 vorzugsweise um den magischen Winkel $\theta$ ($\theta$ = 54,74°) verkippt (s. Fig. 8).

**Fig. 5** zeigt eine erfindungsgemäße Sende-Empfangsspule **1d** mit periodisch variierender Leiterbahnbreite W innerhalb jeder Windung **3e**, die als zero-pitch Spule ausgebildet ist. Die Windungen 3e sind in Form von nicht geschlossenen Ringen ausgebildet, die über Verbindungsabschnitte **22** miteinander verbunden sind. Die Steigung S innerhalb jeder Windung 3d beträgt null. Durch die Verbindungsabschnitte 22 wird insgesamt eine konstante Ganghöhe P = konst. realisiert.

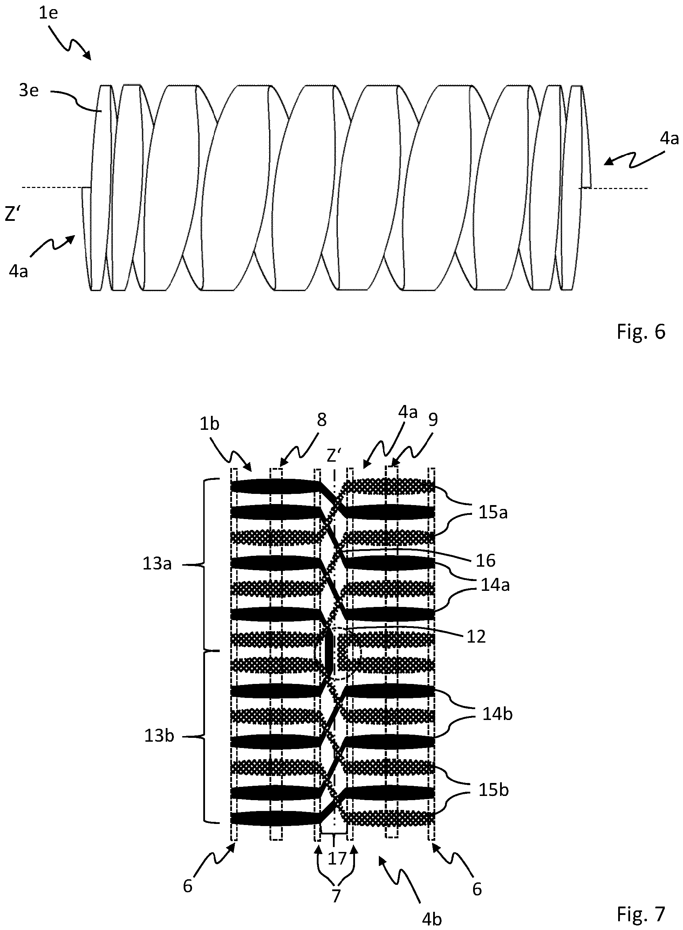

**Fig. 6** zeigt eine erfindungsgemäße Sende-Empfangsspule **1e** mit innerhalb jeder Windung periodisch variierender Leiterbahnbreite und variierender Ganghöhe P wobei sowohl die Ganghöhe P als auch die Leiterbahnbreite W entlang der Achse Z' variiert, d.h. die Ganghöhe P und die maximale Breite der Leiterbahn ändert sich in Abhängigkeit von der axialen Position der Windung. In dem in Fig. 6 gezeigten Beispiel nehmen sowohl Ganghöhe P als auch Leiterbahnbreite W zu den axialen Enden 4a, 4b hin ab.

Die **Fig. 7** zeigt in einer Abwicklungsdarstellung eine spezielle Ausführungsform einer ersten Sende-Empfangsspule **1b** für einen erfindungsgemäßen NMR-Probenkopf. Auch hier variiert die Leiterbahnbreite W erfindungsgemäß innerhalb jeder Windung zweimal. Es handelt sich hier um eine zero-pitch Spule, so dass sich die Bereiche 8, 9 mit maximaler Leiterbahnbreite gegenüberliegen. Ebenso liegen sich die Bereiche 6, 7 mit minimaler Leiterbahnbreite gegenüber.

In der hier gezeigten Ausführungsform weist die erste Sende-Empfangsspule 1b zwei Spulenabschnitte **13a, 13b** mit Hinwindungen **14a, 14b** auf, die von einem Anschlussbereich **12** zu je einem axialen Ende **4a, 4b** der Sende-Empfangsspule 1b verlaufen, und Rückwindungen **15a, 15b** auf, die von dem jeweiligen axialen Ende 4a, 4b zurück zum Anschlussbereich 12 verlaufen. Die Rückwindungen 15a, 15b weisen eine bezüglich der Hinwindungen 14a, 14b entgegengesetzte Ganghöhe P auf. Die zurückgeführten Leiter (Rückwindungen 15a, 15b) verlaufen dabei auf derselben Fläche (hier: Zylindermantelfläche; nicht näher dargestellt) wie die hinführenden Leiter (Hinwindungen 14a, 14b). Die Hinwindungen 14a, 14b und die Rückwindungen 15a, 15b sind auf der gemeinsamen Zylindermantelfläche um die Längsachse Z' angeordnet. Die Rückwindungen 15a, 15b sind in den Räumen zwischen zwei Hinwindungen 14a, 14b angeordnet. Die hierfür notwendigen Überkreuzungen **16** werden hier auf einem möglichst wenig ausgedehnten Abschnitt des Umfangs (Überkreuzungsbereich **17**) ausgeführt. Die Überkreuzungen 16 der Hin- und Rückwindungen 14, 14b, 15a, 15b können beispielsweise mittels Brückenelemente ausgeführt sein, die als Verbindungselemente aus der gemeinsamen Umfangsfläche heraus- und hineinführen (nicht näher dargestellt).

Bei der hier gezeigten Geometrie der Sende-Empfangsspule 1b werden also Windungen mit gegensätzlichen Potentialen auf demselben radialen Abstand zur Längsachse Z' der ersten Sende-Empfangsspule 1b angeordnet und zwar derart, dass sich die Potentiale benachbarter Windungen 14a-15a; 14b-15b kompensieren, d. h. betragsmäßig möglichst ähnlich sind aber entgegengesetzte Vorzeichen aufweisen. Das elektrische Feld konzentriert sich auf die Zwischenräume und klingt mit zunehmendem Abstand zur Sende-Empfangsspule 1b sehr schnell ab. Die elektrischen Felder verlaufen nur wenig ins Innere der Sende-Empfangsspule 1b, wo sich das Field of View befindet, in dem eine Messprobe angeordnet wird. Dadurch ergibt sich, dass minimale elektrische Felder in die Messprobe eingebracht werden. Für kryogen gekühlte NMR-Messköpfe kann ein gutes Signal-Rausch-Verhältnis auch im Betrieb mit verlustbehafteten Messproben garantiert werden.

Die hier gezeigte Sende-Empfangsspule 1b kann auch als Ausführungsform mit nur einem Spulenabschnitt realisiert werden. In diesem Fall befindet sich der Anschlussbereich an einem der axialen Enden. Der elektrische Leiter wird dann zum gegenüberliegenden axialen Ende hin in einem vorgegebenen Windungssinn und wieder zurück zum Anschlussbereich mit entgegengesetzter Ganghöhe P und demselben Windungssinn geführt.

Fig. 8 zeigt eine spezielle Ausführungsform der erfindungsgemäßen Sende-Empfangsspule **1g** mit geneigten Windungen. Die Leiterbahnbreite W ändert sich bei der Sende-Empfangsspule 1g periodisch und weist pro Windung vier Maxima und vier Minima auf: zwei Minima entlang der Neigungsachse (X'-Richtung), um eine Transparenz für ein zweites HF-Magnetfeld B2 einer Kreuzspulenkonfiguration zu erzeugen, und zwei Minima senkrecht zur Neigungsachse (entlang der Y'-Richtung), um "sich selbst weniger im Weg zu stehen". Diese Minima optimieren i.d.R. für Sende-Empfangsspulen mit geneigten Windungen die Performance der ersten Sende-Empfangsspule 1g, wohingegen die Minima, welche die Transparenz erhöhen, die Performance der weiteren Sende-Empfangsspule (in Fig. 8 nicht gezeigt) zu Lasten der ersten Sende-Empfangsspule 1g optimieren.

**Fig. 8** zeigt eine schematische Darstellung eines erfindungsgemäßen NMR-Probenkopfs **23**. Ein statisches Magnetfeld zur Durchführung von NMR-Messungen wird während des Betriebs im hier gezeigten Beispiel parallel zu einer Z-Achse ausgerichtet sein. Der NMR-Probenkopf 23 umfasst eine erfindungsgemäße Sende-Empfangsspule 1, die an ein Anpassnetzwerk 24 angeschlossen ist und weiterhin einen Spektrometeranschluss **21.** Bei dem in Fig. 8 gezeigten NMR-Probenkopf handelt es sich um einen MAS (magic angle spinning) Probenkopf, bei dem die Längsachse Z' der Sende-Empfangsspule 1 gegenüber der Z-Achse, entlang der die längliche Ausdehnung des NMR-Probenkopfs 23 verläuft, vorzugsweise um den magischen Winkel $\theta$ ($\theta$ = 54,74°) verkippt ist.

Bezugszeichenliste

| | |
|---|---|
| 1, 1a-1e, 1g | erste Sende-Empfangsspule |
| 2 | elektrischer Leiter der ersten Sende-Empfangsspule (Leiterbahn) |
| 3 | Windungen der ersten Sende-Empfangsspule |
| 3' | zentrale Windung der ersten Sende-Empfangsspule |
| 3″ | endständige Windung der ersten Sende-Empfangsspule |
| 4a, 4b | axiale Enden der ersten Sende-Empfangsspule |
| 5, 5' | Hälften der weiteren Sende-Empfangsspule 11 |
| 6 | erster Bereich der Windungen mit einer minimalen Leiterbahnbreite |
| 7 | zweiter Bereich der Windungen mit einer minimalen Leiterbahnbreite |
| 8 | dritter Bereich der Windungen mit einer maximalen Leiterbahnbreite |
| 9 | vierter Bereich der Windungen mit einer maximalen Leiterbahnbreite |
| 10 | Zwischenraum zwischen Windungen der ersten Sende-Empfangsspule |
| 11 | weitere Sende-Empfangsspule |
| 12, 12a, 12b | Anschlussbereich der ersten Sende-Empfangsspule |
| 13a, 13b | Spulenabschnitt der ersten Sende-Empfangsspule |
| 14a, 14b | Hinwindungen des Spulenabschnitts |
| 15a, 15b | Rückwindungen des Spulenabschnitts |
| 16 | Überkreuzungen des elektrischen Leiters |
| 17 | Überkreuzungsbereich |
| 21 | Spektrometeranschluss |

| 22 | Verbindungsabschnitte |
|---|---|
| 23 | NMR-Probenkopf |
| 24 | Anpassnetzwerk |
| 100 | Sende-Empfangsspulenanordnung mit zwei Sende-Empfangsspulen |

| d | Leiterbahndicke des bandförmigen Leiters |
|---|---|
| D | Spaltbreite des Zwischenraums |
| R | Radius der Windungen |
| P | Ganghöhe der Windung |
| S | lokale Steigung |
| T | Neigung der Windungen |
| W | Leiterbahnbreite der Leiterbahn |
| Z' | Längsachse |
| Z | Richtung des statischen Magnetfelds / längliche Ausdehnung des Probenkopfs |

Referenzliste

[Gorkov 2007] Gor′kov et al.
Using low-E resonators to reduce RF heating in biological samples for static solid-state NMR up to 900 MHz Journal of Magnetic Resonance 185 (2007) 77-93

[US6751847] US 6 751 847 B1

[Privalov 1996] Privalov et al.

Coil Design for Large-Volume High-B1 Homogeneity for Solid-State NMR Appl ications
Journal of Magnetic Resonance, Series A 123 (1996), 157-160

[Doty 2006] Doty et al.
Using a cross-coil to reduce RF heating by an order of magnitude in triple-resonance multinuclear MAS at high fields
Journal of Magnetic Resonance 182 (2006) 239-253.

**Patentansprüche**

1. NMR-Probenkopf mit einer Sende-Empfangsspulenanordnung (100) mit einer ersten Sende-Empfangsspule (1; 1a; 1b; 1c; 1d, 1e, 1g) zur Erzeugung eines ersten HF-Magnetfeldes B1, wobei die erste Sende-Empfangsspule (1; 1a; 1b; 1c; 1d, 1e, 1g) einen elektrischen Leiter (2) mit mehreren Windungen (3) um eine Längsachse Z' umfasst,

   wobei der elektrische Leiter (2) der ersten Sende-Empfangsspule (1; 1a; 1b; 1c; 1d, 1e, 1g) als bandförmiger Leiter mit einer Leiterbahnbreite W ausgeführt ist,
   **dadurch gekennzeichnet,**
   **dass** die Leiterbahnbreite W innerhalb jeder Windung (3) mindestens zweimal abnimmt und zweimal zunimmt.

2. NMR-Probenkopf nach Anspruch 1, **dadurch gekennzeichnet, dass** die Leiterbahnbreite W periodisch variiert, wobei insbesondere die Bereiche des elektrischen Leiters (2) mit minimalen Werten für die Leiterbahnbreite W bezüglich einer Rotation um die Längsachse um 180° versetzt angeordnet sind.

3. NMR-Probenkopf nach einem der vorhergehenden Ansprüche, **dadurch gekennzeichnet, dass** die Leiterbahndicke d des Leiters (2) maximal 500 μm beträgt und/oder mindestens so groß ist wie die doppelte Eindringtiefe des HF-Stromes in den elektrischen Leiter (2).

4. NMR-Probenkopf nach einem der vorhergehenden Ansprüche, **dadurch gekennzeichnet, dass** die Leiterbahnbreite W zwischen 0,5 mm und 2 mm variiert.

5. NMR-Probenkopf nach einem der vorhergehenden Ansprüche, **dadurch gekennzeichnet, dass** die Windungen (3) der Sende-Empfangsspule (1c, 1g) gegenüber der Längsachse der Sende-Empfangsspule (1c, 1g) geneigt sind.

6.  NMR-Probenkopf nach einem der vorhergehenden Ansprüche, **dadurch gekennzeichnet, dass** die Sende-Empfangsspulenanordnung (1a) mindestens eine weitere Sende-Empfangsspule (11) zur Erzeugung eines zweiten HF-Magnetfelds B2 umfasst,

    dass die erste Sende-Empfangsspule (1a) und die weitere Sende-Empfangsspule (11) um die gemeinsame Längsachse Z' angeordnet sind, derart, dass durch die erste Sende-Empfangsspule (1a) und die weitere Sende-Empfangsspule (11) erzeugte HF-Magnetfelder B1, B2 senkrecht zueinander ausgerichtet sind, und
    dass die Leiterbahnbreite W des elektrischen Leiters (2) der ersten Sende-Empfangsspule (1a) in dem Bereich (6,7), in dem die Flächennormale der ersten Sende-Empfangsspule (1a) parallel zum zweiten HF-Magnetfeld B2 steht, einen minimalen Wert aufweist.

7.  NMR-Probenkopf nach Anspruch 6, **dadurch gekennzeichnet, dass** die weitere Sende-Empfangsspule (11) eine Sattelspule oder ein Resonator ist.

8.  NMR-Probenkopf nach einem der vorhergehenden Ansprüche, **dadurch gekennzeichnet, dass** der elektrische Leiter (2) der ersten Sende-Empfangsspule (1; 1a; 1b; 1c; 1d, 1e, 1g) mindestens einen solenoidförmigen Abschnitt aufweist.

9.  NMR-Probenkopf nach Anspruch 8, **dadurch gekennzeichnet,**

    **dass** der elektrische Leiter (2) der ersten Sende-Empfangsspule (1b) einen Hinwicklungsabschnitt und einen Rückwicklungsabschnitt umfasst, wobei der Hinwicklungsabschnitt Hinwindungen (14a, 14b) umfasst und ausgehend von einem Anschlussbereich (12) in einem vorgegebenen Windungssinn zu einem axialen Ende (4a, 4b) der Sende-Empfangsspule (1b) führt, wobei der Rückwicklungsabschnitt Rückwindungen (15a, 15b) umfasst und ausgehend vom axialen Ende (4a, 4b) der ersten Sende-Empfangsspule (1b) im vorgegebenen Windungssinn zum Anschlussbereich (12) führt, wobei die Windungen des Rückwicklungsabschnitts eine Ganghöhe P mit entgegengesetztem Vorzeichen zu denen des Hinwicklungsabschnitts aufweisen, und
    **dass** Hin- und Rückwindungen (14a, 14b, 15a, 15b) des elektrischen Leiters (2) mit Ausnahme von Überkreuzungsbereichen (17), in denen sich die Hin- und Rückwindungen (14a, 14b, 15a, 15b) überkreuzen, auf einer gemeinsamen Zylindermantelfläche um die Längsachse Z' angeordnet sind.

10. NMR-Probenkopf nach Anspruch 9, **dadurch gekennzeichnet, dass** die Hinwindungen und Rückwindungen (14a, 14b, 15a, 15b) abwechselnd angeordnet sind.

11. NMR-Probenkopf nach einem der vorhergehenden Ansprüche, **dadurch gekennzeichnet, dass** die Steigung S, insbesondere die Ganghöhe P, der Windungen (3) der ersten Sende-Empfangsspule (1c) entlang des Verlaufs des elektrischen Leiters (2) variiert.

12. NMR-Probenkopf nach Anspruch 11, **dadurch gekennzeichnet, dass** die Ganghöhe P an den axialen Enden (4a, 4b) der ersten Sende-Empfangsspule (1c) kleiner ist als am axialen Zentrum (20).

13. NMR-Probenkopf nach einem der vorhergehenden Ansprüche, **dadurch gekennzeichnet, dass** die Windungen (3) der ersten Sende-Empfangsspule (1d) entlang der Längsachse Z' der ersten Sende-Empfangsspule (1d) eine variable Neigung T gegenüber der Längsachse Z' aufweisen.

14. MR-Probenkopf nach Anspruch 13, **dadurch gekennzeichnet, dass** mindestens ein Abschnitt einer Windung (3) senkrecht zur Längsachse Z' ausgerichtet ist.

Fig. 1

Fig. 2a

Fig. 2b

Fig. 3a

Fig. 3b

1c

3c

Z'

Fig. 4

1d

22

3c

Z'

Fig. 5

Fig. 6

Fig. 7

**Fig. 8**

Fig. 9

Europäisches
Patentamt

European
Patent Office

Office européen
des brevets

# EUROPÄISCHER RECHERCHENBERICHT

Nummer der Anmeldung

EP 23 18 2250

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2005/146331 A1 (FLEXMAN JOHN H [AU] ET AL) 7. Juli 2005 (2005-07-07) * Absatz [0001] * * Absatz [0111] – Absatz [0114] * * Absatz [0146] * * Abbildungen 6a, 18 * | 1-8,11, 13,14 | INV. G01R33/34 |
| X | US 2012/074935 A1 (CROZIER STUART [AU] ET AL) 29. März 2012 (2012-03-29) * Absatz [0037] * * Absatz [0065] * * Abbildungen 1(a), 15(b), 15(c) * | 1-5,8, 11-14 | |
| A | COLLIER KELSEY A ET AL: "Design and construction of a quadruple-resonance MAS NMR probe for investigation of extensively deuterated biomolecules", JOURNAL OF MAGNETIC RESONANCE, Bd. 285, 12. Oktober 2017 (2017-10-12), Seiten 8-17, XP085253425, ISSN: 1090-7807, DOI: 10.1016/J.JMR.2017.10.002 * Abbildung 1 * | 1-14 | RECHERCHIERTE SACHGEBIETE (IPC) G01R |
| A | US 6 087 832 A (DOTY F DAVID [US]) 11. Juli 2000 (2000-07-11) * Spalte 3, Zeilen 29-58 * * Abbildung 1 * | 1-14 | |
| A | JP 2009 216579 A (HITACHI LTD) 24. September 2009 (2009-09-24) * Abbildungen 3, 4, 8, 9 * | 1-14 | |

–/––

Der vorliegende Recherchenbericht wurde für alle Patentansprüche erstellt

| Recherchenort | Abschlußdatum der Recherche | Prüfer |
|---|---|---|
| München | 13. November 2023 | Streif, Jörg Ulrich |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes Dokument

EPO FORM 1503 03.82 (P04C03)

**Seite 1 von 2**

Europäisches
Patentamt

European
Patent Office

Office européen
des brevets

## EUROPÄISCHER RECHERCHENBERICHT

Nummer der Anmeldung

EP 23 18 2250

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | PRIVALOV A.F ET AL: "Coil Design for Large-Volume High-B1 Homogeneity for Solid-State NMR Applications", JOURNAL OF MAGNETIC RESONANCE. SERIES A, 1. Dezember 1996 (1996-12-01), Seiten 157-160, XP093066122, DOI: 10.1006/jmra.1996.0229 * Abbildung 1 * ----- | 1-14 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| München | 13. November 2023 | Streif, Jörg Ulrich |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 18 2250

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-11-2023

| Im Recherchenbericht angeführtes Patentdokument | Datum der Veröffentlichung | Mitglied(er) der Patentfamilie | Datum der Veröffentlichung |
|---|---|---|---|
| US 2005146331 A1 | 07-07-2005 | US 2005146331 A1<br>WO 03096041 A1 | 07-07-2005<br>20-11-2003 |
| US 2012074935 A1 | 29-03-2012 | EP 2281208 A1<br>US 2012074935 A1<br>WO 2009124340 A1 | 09-02-2011<br>29-03-2012<br>15-10-2009 |
| US 6087832 A | 11-07-2000 | KEINE | |
| JP 2009216579 A | 24-09-2009 | JP 5290598 B2<br>JP 2009216579 A | 18-09-2013<br>24-09-2009 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6751847 B

- US 6751847 B1

**In der Beschreibung aufgeführte Nicht-Patentliteratur**

- **GORKOV.** Using low-E resonators to reduce RF heating in biological samples for static solid-state NMR up to 900 MHz. *Journal of Magnetic Resonance,* 2007, vol. 185, 77-93
- **PRIVALOV.** Coil Design for Large-Volume High-B1 Homogenity for Solid-State NMR Appl ications. *Journal of Magnetic Resonance, Series A,* 1996, vol. 123, 157-160

- **DOTY.** Using a cross-coil to reduce RF heating by an order of magnitude in triple-resonance multinuclear MAS at high fields. *Journal of Magnetic Resonance,* 2006, vol. 182, 239-253